# EUROPÄISCHE PATENTSCHRIFT

(11) **EP 0 986 064 B1**
(45) Veröffentlichungstag und Bekanntmachung des Hinweises auf die Patenterteilung: **14.12.2005**
(21) Anmeldenummer: 99116795.8
(22) Anmeldetag: 01.09.1999
(51) Int. Cl.: G11C 8/00, G11C 5/14

(54) **Integrierter Halbleiterspeicher**
Integrated semiconductor memory
Mémoire à semiconducteurs intégrée

(30) Priorität: 08.09.1998 DE 19840983
(43) Veröffentlichungstag der Anmeldung: 15.03.2000
(73) Patentinhaber: Infineon Technologies AG, 81669 München (DE)
(72) Erfinder: Le, Thoai-Thai, 81737 München (DE); Brox, Martin, Dr., 81825 München (DE); Lindolf, Jürgen, Dr., 86316 Friedberg (DE); Brass, Eckhard, Dr., 82008 Unterhaching (DE)
(74) Vertreter: Patentanwaltskanzlei WILHELM & BECK

(56) Entgegenhaltungen:
- EP-A- 0 871 178
- DE-A- 19 639 701
- US-A- 5 251 178
- US-A- 5 615 162
- US-A- 5 659 519
- US-A- 6 031 780

## Beschreibung

Die Erfindung betrifft einen integrierten Halbleiterspeicher mit einer Vielzahl von Speicherzellen, die in mindestens zwei Speicherbänken angeordnet sind.

Integrierte Halbleiterspeicher enthalten eine Vielzahl von Speicherzellen. Wie in der US 5 109 265 gezeigt, sind die Speicherzellen in vier Speicherbänke aufgeteilt.

Auf dem integrierten Halbleiterspeicher werden aus der zugeführten Versorgungsspannung verschiedene weitere Spannungen bzw. Potentiale erzeugt und an das Speicherzellenfeld angelegt. Beispielsweise wird an das Substrat eine Substratvorspannung angelegt; an die Wortleitungen der Speicherbänke wird eine Wortleitungspannung angelegt; die Bitleitungen werden mit einer Bitleitungsspannung gespeist. Das Substratpotential liegt unterhalb der dem Halbleiterchip von außen zugeführten Versorgungsspannung, das Wortleitungspotential liegt oberhalb der von außen zugeführten Versorgungsspannung, und das Bitleitungspotential liegt innerhalb der von außen zugeführten Versorgungsspannung. Die jeweiligen Spannungsgeneratoren verbrauchen Verlustleistung, die insbesondere im Fall der Substratvorspannung und Wortleitungspannung nicht unbedeutend ist.

Mit zunehmender Speichergröße nehmen auch die von den jeweiligen Spannungsquellen zu treibenden kapazitiven Lasten, z.B. Wortleitungs-, Bitleitung- oder Substratkapazität, zu. Dies erfordert höhere Treiberfähigkeit der entsprechenden Spannungsgeneratoren. Mit zunehmender Speichergröße steigt daher die Verlustleistung der Spannungsquellen und bleibt gegenüber den übrigen Verlustleistungsquellen nicht mehr vernachlässigbar. Ab einer Speichergröße von ca. 1 Gbit wird dieser Effekt bemerkenswert.

In der DE 196 13 667 A1 ist ein Halbleiterspeicher beschrieben, bei dem der Spannungsgenerator für die Wortleitungsspannung während des Refresh oder CBR-Modus mit höherer Treiberfähigkeit betrieben wird und ansonsten mit niedrigerer Treiberfähigkeit. Alle betrachteten Speicherzellen werden vom gleichen Adreßdekoder angesteuert.

In der US 5659519 ist ein Halbleiterspeicher beschrieben, der umfasst eine Vielzahl von Speicherbäure, dabei jede von einem Versorgungspotential gespeist wird. Je eine den Speicherbäuren Zugeordnete Versorgungsspannungquelle bereitstellt den jeweilige Versorgungspotential.

Die Aufgabe der Erfindung besteht darin, einen integrierten Halbleiterspeicher mit geringer Verlustleistung anzugeben.

Diese Aufgabe wird durch einen integrierten Halbleiterspeicher mit den Merkmalen des Patentanspruchs 1 gelöst.

Gemäß der Erfindung wird jeder Speicherbank des integrierten Halbleiterspeicherchips eine Versorgungsspannungquelle zugeordnet. Die Versorgungsspannungsquelle erzeugt alternativ oder kombiniert Wortleitungs-, Bitleitungs- oder Substratpotential. Wenn eine Speicherbank bei einem Speicherzugriff aktiviert wird, wozu sich ein entsprechend decodiertes Adreßsignal eignet, wird die Treiberfähigkeit der zugeordneten Versorgungsspannungsquelle erhöht. Wenn eine andere Speicherbank aktiviert wird und die betrachtete Speicherbank daraufhin deaktiviert wird, dann wird die Treiberfähigkeit dieser Versorgungsspannungsquelle wieder erniedrigt. Verlustleistung wird dementsprechend gespart. Die Versorgungsspannungsquelle wird bei Aktivierung der zugeordneten Speicherbank unter Vollast betrieben. Bei Deaktivierung der Speicherbank wird die Spannungsquelle mit gegenüber Vollast niedriger Treiberleistung betrieben derart, daß nur noch Leckstromverluste im Speicherzellenfeld ausgeglichen werden; oder sie wird vollständig abgeschaltet.

Die Versorgungsspannungsquellen für das Wortleitungs- und das Substratpotential sind sogenannte Spannungsbooster, deren erzeugte Ausgangsspannung bzw. das erzeugte auf Bezugspotential bezogene Ausgangspotential außerhalb der eingangsseitig zugeführten Versorgungsspannung liegen. Solche Spannungsquellen werden taktweise betrieben und enthalten einen Oszillator. Beim Umschalten von Vollast auf Teillast wird lediglich die Taktfrequenz der Spannungsquelle abgesenkt.

Vorteilhafte Ausgestaltungen der Erfindung für die Wortleitungsspannung, Substratvorspannung oder Bitleitungspannung sind in Unteransprüchen angegeben.

Nachfolgend wird die Erfindung anhand der Zeichnung näher erläutert.

Es zeigen
- Figur 1: ein Prinzipschaltbild eines integrierten Halbleiterspeichers gemäß der Erfindung,
- Figur 2: einen detaillierten Ausschnitt für eine Ausführung zur Erzeugung der Wortleitungsspannung und
- Figur 3: einen detaillierten Ausschnitt für eine Ausführung zur Erzeugung der Bitleitungspannung.

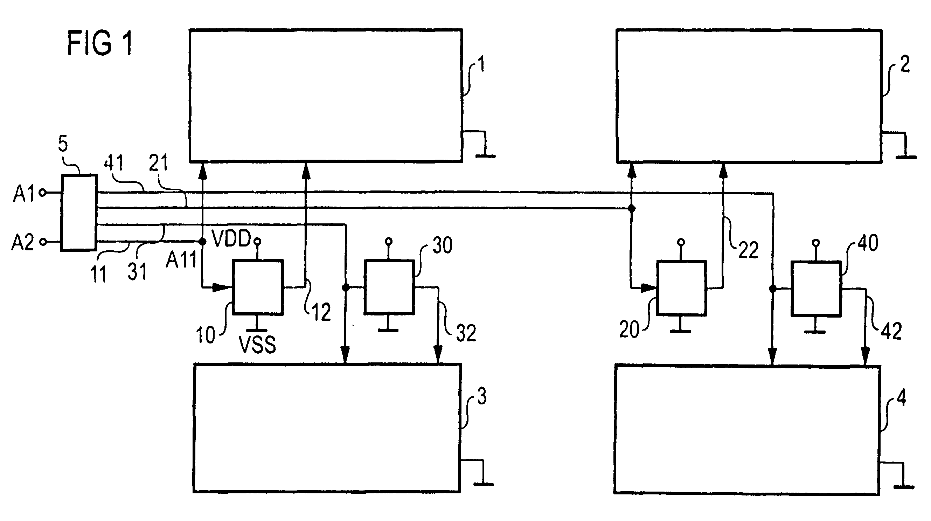

Das in der Figur 1 dargestellte Blockschaltbild eines Halbleiterspeichers zeigt vier Speicherbänke 1, 2, 3, 4. Jede Speicherbank enthält eine Vielzahl von Speicherzellen sowie die entsprechenden Funktionseinheiten zum Lesen und Beschreiben der Speicherzellen in der Speicherzellenbank. Bei einem 1 Gbit-Speicher weist jede Speicherbank eine Speicherkapazität von 256 Mbit auf. Eine Speicherbank ist über eine jeweilige Adresse auswählbar. Zur Auswahl dienen beispielsweise die beiden höchstwertigen Bits A1, A2 der Adresse der entsprechenden Speicherzelle. Diese Bits, die gegebenenfalls erst nach einem vorgeschalteten Decodiervorgang erhalten werden, werden einem Decoder 5 zugeführt. Ausgangsseitig weist der Decoder 5 je eine Leitung 11, 21, 31, 41 für die Speicherbänke 1, 2, 3 bzw. 4 auf. Wenn eine der Leitungen 11, 21, 31, 41 aktiviert wird, bedeutet dies, daß ein Speicherzugriff auf eine der Speicherzellen in der der jeweiligen Leitung zugeordneten Speicherbank erfolgt. Die Speicherbank wird dann aktiv geschaltet, d. h. sämtliche Versorgungsspannungen und für einen Speicherzugriff ansonsten erforderlichen Funktionseinheiten in der jeweiligen Speicherbank werden in einen Zustand versetzt, so daß ein Lesen oder Schreiben einer Speicherzelle in der Speicherbank ermöglicht wird.

Jeder der Speicherbänke 1, 2, 3, 4 ist eine separate Versorgungsquelle 10, 20, 30 bzw. 40 zugeordnet. Die Versorgungsspannungsquelle 10 erzeugt eine Wortleitungspannung, Bitleitungspannung oder Substratvorspannung bzw. das entsprechende Potential gegenüber Masse VSS an einer Ausgangsleitung 12, die der Speicherbank 1 zugeführt wird. Die Versorgungsspannungsquelle 10 kann auch eine oder mehrere dieser Versorgungsspannungen parallel bereitstellen. Die Quelle 10 ist derart gesteuert, daß sie das Potential mit einer höheren Treiberfähigkeit abgibt, wenn die Speicherbank 1 aktiviert ist, das heißt ein Zugriff auf eine der in ihr angeordneten Speicherzellen erfolgt. Wenn die Speicherbank 1 deaktiviert ist, wenn also ein Zugriff auf eine der anderen Speicherbänke 2, 3, 4 abläuft, wird die jeweilige Versorgungsspannung bzw. das Potential am Ausgang 12 der Versorgungsspannungsquelle 10 mit niedriger Treiberfähigkeit bereitgestellt. Dies schließt auch ein, daß die Versorgungsspannungsquelle 10 vollständig abgeschaltet wird.

Bei niedriger Treiberleistung bzw. Abschaltung der Versorgungsspannungsquelle 10 verbraucht diese kaum bzw. keine Verlustleistung. Wenn ein Speicherzugriff nur auf eine einzelne Speicherzelle erfolgt und nur die jeweilige Speicherbank aktiviert ist, während die anderen Speicherbänke deaktiviert sind, beträgt die Verlustleistung der Spannungsgeneratoren im günstigsten Fall nur ein Viertel gegenüber einem herkömmlichen Versorgungsspannungsquellenkonzept, bei dem alle Speicherbereiche gleich versorgt werden.

Die Umschaltung zwischen hoher und niedriger Treiberleistung der Versorgungsspannungquelle 10 wird zweckmäßigerweise durch das Signal an der Decoderausgangsleitung 11 bewirkt. Hierzu ist die Leitung 11 sowohl mit der Speicherbank 1 als auch mit dem entsprechenden Steuereingang zur Steuerung der Treiberleistung der Versorgungsspannungsquelle 10 verbunden. Die anderen Versorgungsspannungsquellen 20, 30, 40 weisen eine der obigen Beschreibung entsprechende Funktion und einen entsprechenden Aufbau auf.

In der Figur 1 ist jeder Speicherbank eine separate Versorgungsspannungsquelle zugeordnet. Dies schließt aber in der praktischen Realisierung auch ein, daß Teile dieser Versorgungsspannungsquellen gemeinsam von verschiedenen Speicherbänken benutzt werden. Zweckmäßig ist, daß Teile der Versorgungsspannungsquellen 10, 30 zusammengefaßt werden und etwa nur die jeweiligen Ausgänge 12, 32 an- und abgeschaltet werden. Entsprechendes gilt für die Quellen 20, 40.

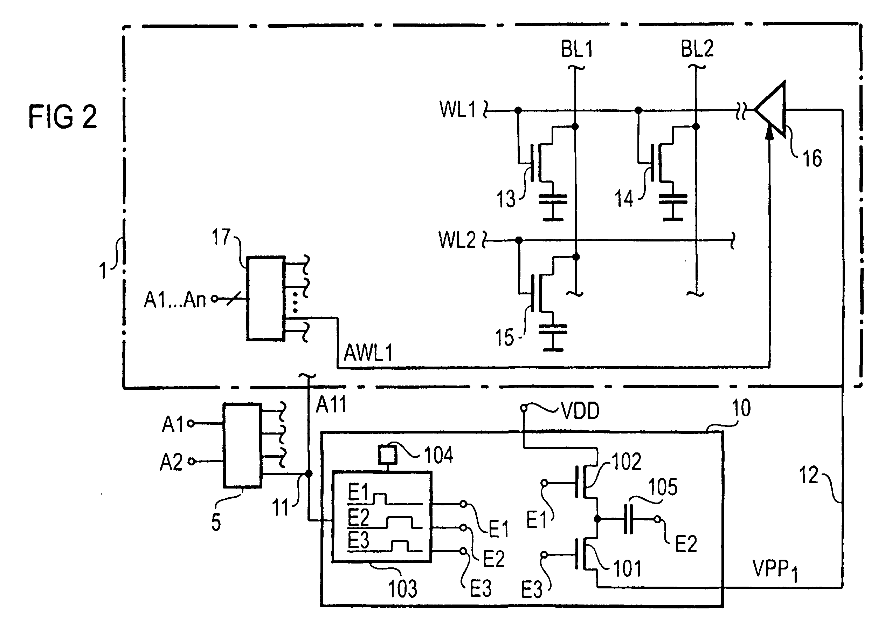

In der Figur 2 ist ein detaillierter Ausschnitt aus einem integrierten Halbleiterspeicher gezeigt, bei dem die Versorgungsspannungsquelle 10 an der Leitung 12 ein Versorgungspotential VPP1 für die Wortleitung der Speicherbank 1 bereitstellt. Die Speicherbank 1 enthält ein Speicherzellenfeld, von dem die Speicherzellen 13, 14, 15 dargestellt sind. Zur Auswahl einer Speicherzelle dienen Wortleitungen WL1, WL2 und Bitleitungen BL1, BL2. Eine Vielzahl von Speicherzellen 13, 14 wird über ein positives Potential an der Wortleitung WL1 angesprochen. Der jeweilige Zugangstransistor der Speicherzelle wird dann leitend geschaltet. Durch die Auswahl einer Bitleitung, z.B. BL1, wird die Dateninformation der am Kreuzungspunkt von Wortleitung WL1 und Bitleitung BL1 angeordneten Speicherzelle 13 ausgelesen. Das Potential VPP1 der Wortleitung WL1 im aktivierten Zustand liegt oberhalb des dem Halbleiterchip von außen zugeführten Versorgungspotentials VDD. Dadurch wird bewirkt, daß die als n-Kanal-MOS-Transistoren ausgeführten Zugangstransistoren der Speicherzellen vollständig leitend gesteuert sind und die in der Speicherzelle gespeicherte Information ohne Verluste ausgelesen und ohne Verluste eingelesen werden kann. Die über die Leitung 12 angelegte Spannung ist also größer als die von außen angelegte Versorgungsspannung VDD, VSS. Das Versorgungspotential VPP1 der Leitung 12 wird über je einen schaltbaren Verstärker an die Wortleitungen angelegt, von denen der Verstärker 16 für die Wortleitung BL1 dargestellt ist. Der Verstärker 16 wird aktiviert, so daß das Potential VPP1 der Leitung 12 an die Wortleitung WL1 durchgeschaltet wird, wenn die Wortleitung WL1 für einen Zugriff auf die Speicherzelle 13 aktiviert wird. Hierzu erhält der Zeilendecoder 17 die Adresse A1, ..., An der Speicherzelle 13 bzw. eine daraus bereits vordecodierte Adresse, und ein von einem Zeilendecoder 17 erzeugtes Steuersignal AWL1 wird dem Verstärker 16 zugeführt.

Zur Erzeugung des erhöhten Versorgungspotentials VPP1 an Leitung 12 ist die Versorgungsspannungsquelle 10 als Ladungspumpe oder Boostschaltung ausgeführt. Sie enthält zwei mit ihren Drain-Source-Strecken in Reihe geschaltete n-Kanal-MOS-Transistoren 101, 102, die zwischen dem Versorgungspotentialanschluß VDD des Halbleiterchips und den Ausgangsanschluß 12 geschaltet sind. An den Kopplungsknoten der Transistoren 101, 102 ist ein Kondensator 105 angeschlossen. Die Gate-Anschlüsse der Transistoren sowie der andere Anschluß des Kondensators werden von je einem Steuersignal E1, E2 bzw. E3 gesteuert. Die Steuersignale E1, E2 und E3 werden in einer Logikeinrichtung 103 erzeugt, die von einem Oszillator 104 getrieben wird. Zur Erzeugung der erhöhten Ausgangsspannung bei einem Speicherzugriff wird die Ladungspumpe 10 bei Vollast betrieben, d. h. die Treiberfähigkeit bezüglich des Ausgangspotentials VPP1 am Anschluß 12 ist hoch. Hierzu werden die periodischen Steuersignale E1, E2, E3 mit hoher Frequenz erzeugt. Wenn kein Speicherzugriff auf die Speicherbank 1 erfolgt und daher durch das Signal A11 am Anschluß 11 des Decoders 5 die Speicherbank 1 abgeschaltet ist, liegt das Potential VPP1 am Ausgangsanschluß 12 der Versorgungsspannungsquelle 10 mit geringerer Treiberfähigkeit vor. Dies bedeutet, daß entweder die Versorgungsspannungsquelle 10 vollständig abgeschaltet ist oder ein Ausgangspotential liefert, das zwar in der Höhe der Wortleitungsspannung im aktiven Zustand liegt, aber geringere Treiberfähigkeit hat. Idealerweise ist die Treiberfähigkeit nur so groß, daß Verluste aus Leckströmen ausgeglichen werden. Zur Umschaltung zwischen diesen Betriebszuständen der Versorgungsspannungsquelle 10 wird ihr eingangsseitig das an Leitung 11 anliegende Signal A11 zugeführt, der auch die Speicherbank 21 aktiviert. Dieses steuert zweckmäßigerweise die Logik 103 zur Erzeugung der Steuersignale E1, E2, E3. Alternativ kann auch die Frequenz des Oszillators 104 von hoher Arbeitsfrequenz auf niedrige Frequenz umgeschaltet werden.

Für das - nicht dargestellte - Ausführungsbeispiel, bei dem die Versorgungsspannungsquelle 10 eine Substratvorspannung erzeugt, führt der Ausgang 12 das Substratpotential VBB gegenüber Masse VSS. Der Ausgang 12 ist anstelle der in der Figur 2 gezeigten Verbindung mit einem Substratanschluß verbunden, welcher das Substratpotential für die Speicherzellenbank 1 bereitstellt. Das Substratpotential ist das niedrigste im gesamten Halbleiterchip auftretende Potential. Es bewirkt, daß einem Potentialanstieg des Substrats aufgrund von Schaltvorgängen entgegengewirkt wird, indem im Substrat auftretende Ladungsträger abgesaugt werden. Dies hat den Effekt, daß Leckströme verringert werden, Sperrschichtkapazitäten erhöht werden und die Latchup-Gefahr verringert wird. Das Substratpotential liegt unterhalb des von außen zugeführten Massepotentials VSS, d. h. die Substratvorspannung liegt unterhalb der von außen zugeführten Versorgungsspannung VDD, VSS des Halbleiterchips. Hierzu ist Transistor 102 abweichend von der Darstellung in Figur 2 als p-Kanal-MOS-Transistor ausgeführt und mit dem negativen Pol VSS der Versorgungsspannung verbunden, die Steuersignale E1, E2 und E3 sind dementsprechend angepaßt.

Die übrigen Versorgungspotentialquellen 20, 30, 40 sind entsprechend der Versorgungsspannungsquelle 10 aufgebaut, gleiches gilt für die Speicherbänke 2, 3, 4 bezüglich der Speicherbank 1.

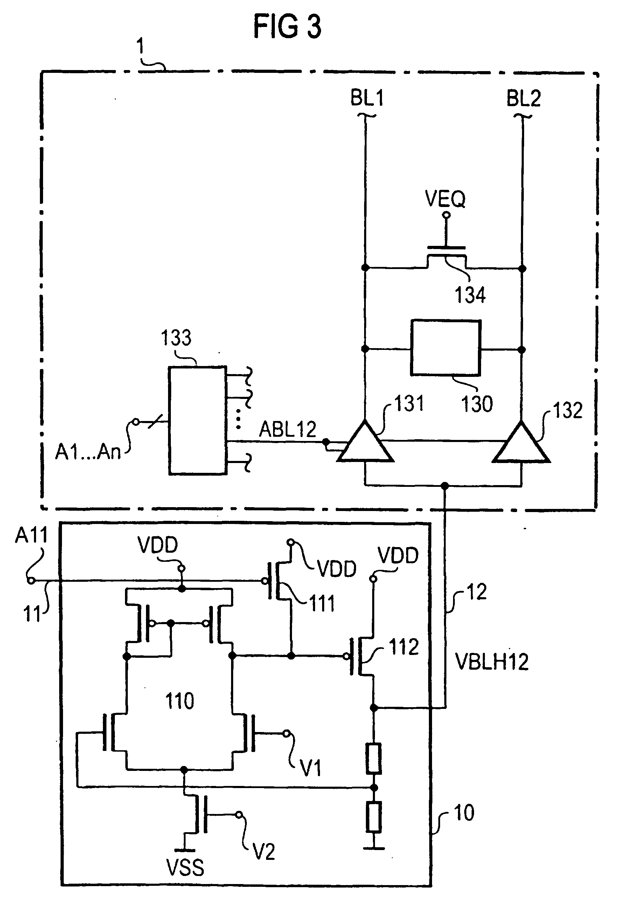

In der Figur 3 ist ein detaillierter Ausschnitt aus einem integrierten Halbleiterspeicher gezeigt, bei dem die Versorgungsspannungsquelle 10 an der Leitung 12 ein Versorgungspotential VBLH12 für die Bitleitungen der Speicherbank 1 bereitstellt. Zwei Bitleitungen BL1, BL2 sind gemeinsam an die gegenphasigen Eingänge eines Leseverstärkers 130 angeschlossen. Vor einem Lesevorgang werden die Bitleitungen BL1, BL2 auf das Versorgungspotential VBLH12 vorgeladen. Anschließend beginnt der Auslesevorgang, indem die Potentiale der Bitleitungen kurzgeschlossen und somit ausgeglichen werden. Hierzu dient ein Transistor 134, der von einem entsprechenden Steuersignal VEQ leitend gesteuert wird. Das Vorladepotential VBLH12 liegt innerhalb der von außen zugeführten Versorgungsspannung des Halbleiterchips VDD, VSS. Das Vorladepotential VBLH12 liegt um ca. 30% niedriger als das positive Versorgungspotential VDD. Durch das Steuersignal A11 wird die Speicherbank 1 sowie die Versorgungsspannungsquelle 10 aktiviert, so daß an deren Ausgangsanschluß 12 die Bitleitungsvorladespannung VBLH12 aufgebaut wird. Die Bitleitungen BL1, BL2 werden nach einem Spaltendecodierungsvorgang aktiviert. Hierzu ist ein Spaltendecoder 133 vorgesehen, der aus den zugeführten Adressen A1, ..., An das decodierte Steuersignal ABL12 aktiviert. Das Steuersignal ABL12 schaltet jeweilige Verstärker 131, 132 an, über die die Bitleitungsvorladespannung VBLH12 an die Bitleitungen BL1, BL2 angelegt wird.

Die Versorgungsspannungsquelle 10 ist in diesem Fall eine geregelte Versorgungsspannungsquelle. Sie enthält einen Operationsverstärker 110. Dieser weist ausgangsseitig einen Strompfad auf, der auf Seite des positiven Versorgungspotentials VDD einen p-Kanal-MOS-Transistor 112 enthält. Der Gateanschluß des Transistors 112 ist über einen weiteren p-Kanal-MOS-Transistor 111 mit einem Anschluß für das Potential VDD verbunden. Der Gateanschluß des Transistors 111 wird vom Signal A11 gesteuert. Dadurch wird der Generator an- und abgeschaltet.

Wie in den Figuren 2 und 3 dargestellt, arbeiten die Speicherbänke in bezug auf Speicherzugriffe unabhängig voneinander. D.h, daß dann, wenn auf eine Speicherbank zugegriffen wird, die andere Speicherbank nicht betroffen ist. Auf die andere Speicherbank kann zeitgleich ebenfalls ein Speicherzugriff ausgeführt werden oder auch nicht. Jede Speicherbank hat einen eigenen, nur ihr zugeordneten Adreßdekoder, der in einen Zeilen- und einen Spaltendekoder, z.B. 17 bzw. 133, aufgeteilt ist. Über den Adreßdekoder einer Speicherbank sind nur die in der Speicherbank angeordneten Speicherzellen adressierbar. Über den gleichen Adreßdekoder sind nicht Speicherzellen verschiedener Speicherbänke adressierbar. Die vom Zeilenadreßdekoder adressierbaren Wortleitungen und die vom Spaltenadreßdekoder adressierbaren Bitleitungen verlaufen nur innerhalb einer Speicherbank, führen aber nicht in die eine andere Speicherbank. Auch Schreib-/Leseverstärker (sense amplifier) dienen nur zum Verstärken von Datensignalen, die von Speicherzellen innerhalb der Speicherbank gespeichert oder ausgelesen werden.

## Patentansprüche

1. Integrierter Halbleiterspeicher umfassend:
- eine erste Speicherbank (1) mit einer Vielzahl von Speicherzellen (13, 14, 15) sowie eine weitere Speicherbank (2, 3, 4), von denen jede einen Adreßdekoder zur Adressierung von Speicherzellen umfaßt, durch den nur Speicherzellen der zugeordneten Speicherbank adressierbar sind, und jede von einem Versorgungspotential (12, 22, 32, 42) gespeist wird,
- je eine den Speicherbänken (1, 2, 3, 4) zugeordnete Versorgungsspannungquelle (10, 20, 30, 40) zur Bereitstellung des jeweiligen Versorgungspotentials, und
- einen Dekoder (5), mit je einem Ausgangssignal (A11) für jede der Speicherbänke (1), durch das die jeweilige Speicherbank (1) für einen Speicherzugriff aktivierbar und deaktivierbar ist, **dadurch gekennzeichnet, daß**
die Versorgungsspannungquellen (10) derart steuerbar sind, daß das Versorgungspotential für eine der Speicherbänke (1) mit höherer Treiberfähigkeit bereitgestellt wird, wenn diese Speicherbank (1) durch das jeweilige Ausgangssignal (A11) aktiviert ist, und mit niedrigerer Treiberfähigkeit bereitgestellt wird, wenn diese Speicherbank (1) durch das jeweilige Ausgangssignal (A11) deaktiviert ist.

2. Integrierter Halbleiterspeicher nach Anspruch 1,
**dadurch gekennzeichnet, daß**
jeder der Versorgungsspannungquellen (10, 20, 30, 40) ihrerseits eine Versorgungsspannung (VDD, VSS) zuführbar ist und daß an der Versorgungsspannungquelle (10, 20, 30, 40) ausgangsseitig ein Versorgungspotential erzeugbar ist, das außerhalb der jeweils zugeführten Versorgungsspannung (VDD, VSS) liegt.

3. Integrierter Halbleiterspeicher nach Anspruch 1 oder 2,
**dadurch gekennzeichnet, daß**
jede der Versorgungsspannungquellen (10) taktweise betrieben wird und daß die Taktfrequenz der Versorgungsspannungquellen (10) von demjenigen Ausgangssignal (A11) des Dekoders (5), durch das die jeweils zugeordnete Speicherbank (1) aktivierbar und deaktivierbar ist, zwischen einer ersten und einer zweiten Frequenz umschaltbar ist.

4. Integrierter Halbleiterspeicher nach Anspruch 1 oder 2,
**dadurch gekennzeichnet, daß**
jede der Versorgungsspannungquellen (10) von demjenigen Ausgangssignal (A11) des Dekoders (5), durch das die jeweils zugeordnete Speicherbank (1) aktivierbar und deaktivierbar ist, einschaltbar und abschaltbar ist.

5. Integrierter Halbleiterspeicher nach einem der Ansprüche 1 bis 4,
**dadurch gekennzeichnet, daß**
der Dekoder (5) eingangsseitig Anschlüsse für ein Adreßsignal (A1, A2) zur Auswahl einer der Speicherbänke (1, 2, 3, 4) der Vielzahl der Speicherzellen (13, 14, 15) aufweist, daß der Dekoder (5) ausgangsseitig für jede der Speicherbänke (1, 2, 3, 4) je einen Anschluß (11, 21, 31, 41) aufweist, daß jeder der Anschlüsse (11, 21, 31, 41) mit der zugeordneten Speicherbank (1, 2, 3, 4) und mit der der Speicherbank zugeordneten Versorgungsspannungquelle (10, 20, 30, 40) verbunden ist.

6. Integrierter Halbleiterspeicher nach einem der Ansprüche 1 bis 5,
**dadurch gekennzeichnet, daß**
jede der Speicherbänke (1) eine Anzahl von Speicherzellen (13, 14, 15) aufweist sowie Wortleitungen (WL1, WL2) aufweist, durch die jeweils mindestens eine der in den Speicherbänken (1) angeordneten Speicherzellen (13, 14, 15) zum Lesen oder Schreiben eines zu speichernden Datenwerts durch ein Steuersignal (AWL1) auswählbar ist, daß durch jede der Versorgungsspannungquellen (10) ein Versorgungspotential (VPP1) für die Wortleitungen (WL1, WL2) erzeugbar ist, und daß das Versorgungspotential (VPP1) für die Wortleitungen über je einen den Wortleitungen (WL1) zugeordneten Schalter (16) zuführbar ist und daß der Schalter (16) von dem Steuersignal (AWL1) leitend steuerbar ist.

7. Integrierter Halbleiterspeicher nach einem der Ansprüche 1 bis 5,
**dadurch gekennzeichnet, daß**
der Halbleiterspeicher in einem Halbleitersubstrat ausgeführt ist, daß durch jede der Versorgungsspannungquellen ein Substratpotential erzeugbar ist, daß das Substratpotential demjenigen Anteil des Substrat zuführbar ist, in dem diejenige Speicherbank, dem die Versorgungsspannungquelle zugeordnet ist, angeordnet ist.

8. Integrierter Halbleiterspeicher nach einem der Ansprüche 1 bis 5,
**dadurch gekennzeichnet, daß**
jede der Speicherbänke (1) eine Anzahl von Speicherzellen (13, 14, 15) aufweist sowie Bitleitungen (BL1, BL2) aufweist, durch die jeweils ein Datenwert von mindestens einer der in den Speicherbänken (1) angeordneten Speicherzellen (13, 14, 15) zum Lesen abgreifbar oder zum Schreiben zuführbar ist, daß durch jede der Versorgungsspannungquellen (10) ein Versorgungspotential (VBLH12) für die Bitleitungen (BL1, BL2) erzeugbar ist, und daß das Versorgungspotential (VBLH12) für die Bitleitungen den Bitleitungen (BL1, BL2) über je einen zugeordneten Schalter (131, 132) zuführbar ist.

9. Integrierter Halbleiterspeicher nach einem der Ansprüche 1 bis 8,
**dadurch gekennzeichnet, daß**
jede Speicherbank (1, 2, 3, 4) einen Adreßdekoder (17, 133) zum Auswählen von Speicherzellen (13, 14, 15) umfaßt, durch welchen Speicherzellen nur dieser Speicherbank auswählbar sind.

## Claims

1. Integrated semiconductor memory comprising:
- a first memory bank (1) having a multiplicity of memory cells (13, 14, 15) and also a further memory bank (2, 3, 4), each of which comprises an address decoder for addressing memory cells, by which address decoder only memory cells of the assigned memory bank can be addressed, and each of which is fed by a supply potential (12, 22, 32, 42),
- a respective supply voltage source (10, 20, 30, 40) assigned to the memory banks (1, 2, 3, 4) and serving for providing the respective supply potential, and
- a decoder (5), having a respective output signal (A11) for each of the memory banks (1), by means of which signal the respective memory bank (1) can be activated for a memory access and can be deactivated,
**characterized in that**
the supply voltage sources (10) can be controlled in such a way that the supply potential for one of the memory banks (1) is provided with higher driver capability if this memory bank (1) is activated by the respective output signal (A11), and is provided with lower driver capability if this memory bank (1) is deactivated by the respective output signal (A11).

2. Integrated semiconductor memory according to Claim 1,
**characterized in that**
each of the supply voltage sources (10, 20, 30, 40) can, for its part, be fed a supply voltage (VDD, VSS), and **in that** a supply potential lying outside the supply voltage (VDD, VSS) respectively fed can be generated at the supply voltage source (10, 20, 30, 40) on the output side.

3. Integrated semiconductor memory according to Claim 1 or 2,
**characterized in that**
each of the supply voltage sources (10) is operated in clocked fashion, and **in that** the clock frequency of the supply voltage sources (10) can be changed over between a first and a second frequency by that output signal (A11) of the decoder (5) by means of which the respectively assigned memory bank (1) can be activated and deactivated.

4. Integrated semiconductor memory according to Claim 1 or 2,
**characterized in that**
each of the supply voltage sources (10) can be switched on and switched off by that output signal (A11) of the decoder (5) by means of which the respectively assigned memory bank (1) can be activated and deactivated.

5. Integrated semiconductor memory according to one of Claims 1 to 4,
**characterized in that**
the decoder (5) has, on the input side, terminals for an address signal (A1, A2) for selecting one of the memory banks (1, 2, 3, 4) of the multiplicity of memory cells (13, 14, 15), **in that** the decoder (5) has, on the output side, a respective terminal (11, 21, 31, 41) for each of the memory banks (1, 2, 3, 4), **in that** each of the terminals (11, 21, 31, 41) is connected to the assigned memory bank (1, 2, 3, 4) and to the supply voltage source (10, 20, 30, 40) assigned to the memory bank.

6. Integrated semiconductor memory according to one of Claims 1 to 5,
**characterized in that**
each of the memory banks (1) has a number of memory cells (13, 14, 15) and also has word lines (WL1, WL2) by means of which in each case at least one of the memory cells (13, 14, 15) arranged in the memory banks (1) can be selected for the reading or writing of a data value to be stored by means of a control signal (AWL1), **in that** a supply potential (VPP1) for the word lines (WL1, WL2) can be generated by each of the supply voltage sources (10), and **in that** the supply potential (VPP1) for the word lines can be fed via a respective switch (16) assigned to the word lines (WL1), and **in that** the switch (16) can be controlled in the on state by the control signal (AWL1).

7. Integrated semiconductor memory according to one of Claims 1 to 5,
**characterized in that**
the semiconductor memory is embodied in a semiconductor substrate, **in that** a substrate potential can be generated by each of the supply voltage sources, **in that** the substrate potential can be fed to that portion of the substrate in which that memory bank to which the supply voltage source is assigned is arranged.

8. Integrated semiconductor memory according to one of Claims 1 to 5,
**characterized in that**
each of the memory banks (1) has a number of memory cells (13, 14, 15) and also has bit lines (BL1, BL2) by means of which a respective data value can be tapped off from at least one of the memory cells (13, 14, 15) arranged in the memory banks (1) for reading or can be fed for writing, **in that** a supply potential (VBLH12) for the bit lines (BL1, BL2) can be generated by each of the supply voltage sources (10), and **in that** the supply potential (VBLH12) for the bit lines can be fed to the bit lines (BL1, BL2) via a respective assigned switch (131, 132).

9. Integrated semiconductor memory according to one of Claims 1 to 8,
**characterized in that**
each memory bank (1, 2, 3, 4) comprises an address decoder (17, 133) for selecting memory cells (13, 14, 15), by which address decoder memory cells only of this memory bank can be selected.

## Revendications

1. Mémoire à semi-conducteurs intégrée comportant :
- un premier banc de mémoire (1) comprenant une pluralité de cellules de mémoire (13, 14, 15) ainsi qu'un autre banc de mémoire (2, 3, 4), parmi lesquels chacun comporte un décodeur d'adresse pour l'adressage des cellules de mémoire, via lequel seules des cellules de mémoire du banc de mémoire associé sont adressables, et parmi lesquels chacun est alimenté par un potentiel d'alimentation (12, 22, 32, 42) ;
- une source de tension d'alimentation (10, 20, 30, 40) associée à chacun des bancs de mémoire (1, 2, 3, 4) pour la mise à disposition du potentiel d'alimentation respectif ; et
- un décodeur (5) comprenant respectivement un signal de sortie (A11) pour chacun des bancs de mémoire (1), via lequel le banc de mémoire respectif (1) peut être activé et désactivé pour un accès de mémoire,
**caractérisée en ce que** les sources de tension d'alimentation (10) peuvent être commandées de sorte que le potentiel d'alimentation est mis à disposition pour un des bancs de mémoire (1) avec une faculté d'excitation plus grande lorsque ce banc de mémoire (1) est activé par le signal de sortie respectif (A11) et avec une faculté d'excitation plus basse lorsque ce banc de mémoire (1) est désactivé par le signal de sortie respectif (A11).

2. Mémoire à semi-conducteurs intégrée selon la revendication 1, **caractérisée en ce qu'**une tension d'alimentation (VDD, VSS) peut être amenée à son tour à chacune des sources de tension d'alimentation (10, 20, 30, 40) et **en ce qu'**un potentiel d'alimentation qui se trouve en dehors de la tension d'alimentation amenée respectivement (VDD, VSS), peut être généré du côté sortie sur la source de tension d'alimentation (10, 20, 30, 40).

3. Mémoire à semi-conducteurs intégrée selon la revendication 1 ou 2, **caractérisée en ce que** chacune des sources de tension d'alimentation (10) est mise en service par cycle et **en ce que** la fréquence de cycle des sources de tension d'alimentation (10) peut être commutée entre une première et une seconde fréquence par le signal de sortie respectif (A11) du décodeur (5), via lequel le banc de mémoire (1) respectivement associé peut être activé et désactivé.

4. Mémoire à semi-conducteurs intégrée selon la revendication 1 ou 2, **caractérisée en ce que** chacune des sources de tension d'alimentation (10) peut être enclenchée et désenclenchée par le signal de sortie respectif (A11) du décodeur (5), via lequel le banc de mémoire (1) respectivement associé peut être activé et désactivé.

5. Mémoire à semi-conducteurs intégrée selon l'une des revendications 1 à 4, **caractérisée en ce que** :
- le décodeur (5) présente sur le côté entrée des raccords pour un signal d'adresse (A1, A2) pour la sélection d'un des bancs de mémoire (1, 2, 3, 4) de la pluralité des cellules de mémoire (13, 14, 15) ;
- le décodeur (5) présente respectivement sur le côté sortie un raccord (11, 21, 31, 41) pour chacun des bancs de mémoire associés (1, 2, 3, 4) ; et
- chacun des raccords (11, 21, 31, 41) est relié au banc de mémoire associé (1, 2, 3, 4) et à la source de tension d'alimentation (10, 20, 30, 40) associée au banc de mémoire.

6. Mémoire à semi-conducteurs intégrée selon l'une des revendications 1 à 5, **caractérisée en ce que** :
- chacun des bancs de mémoire (1) présente un certain nombre de cellules de mémoire (13, 14, 15) ainsi que des lignes de mot (WL1, WL2) via lesquelles au moins une des cellules de mémoire (13, 14, 15) agencées dans les bancs de mémoire (1) peut être sélectionnée via un signal de commande (AWL1) pour lire ou écrire une valeur de données devant être mémorisée ;
- un potentiel d'alimentation (VPP1) peut être généré pour les lignes de mot (WL1, WL2) via chacune des sources de tension d'alimentation (10) ; et
- le potentiel d'alimentation (VPP1) peut être amené pour les lignes de mot via un commutateur (16) associé à chacune des lignes de mot (WL1) ; et
- le commutateur (16) peut être commandé de manière conductrice par le signal de commande (AWL1).

7. Mémoire à semi-conducteurs intégrée selon l'une des revendications 1 à 5, **caractérisée en ce que** :
- la mémoire à semi-conducteurs est réalisée dans un substrat à semi-conducteur ;
- un potentiel de substrat peut être généré via chacune des sources de tension d'alimentation ; et
- le potentiel de substrat peut être amené vers ladite partie du substrat dans laquelle est agencé ledit banc de mémoire auquel est associée la source de tension.

8. Mémoire à semi-conducteurs intégrée selon l'une des revendications 1 à 5, **caractérisée en ce que** :
- chacun des bancs de mémoire (1) présente un certain nombre de cellules de mémoire (13, 14, 15) ainsi que des lignes de bit (BL1, BL2) via lesquelles une valeur de donnée d'au moins une des cellules de mémoire (13, 14, 15) agencées dans les bancs de mémoire (1) peut être saisie pour lire ou amenée pour écrire ;
- un potentiel d'alimentation (VBLH12) peut être généré par chacune des sources de tension d'alimentation (10) pour les lignes de bit (BL1, BL2) ; et
- le potentiel d'alimentation (VBLH12) pour les lignes de bit peut être amené respectivement aux lignes de bit (BL1, BL2) via un commutateur associé (131, 132).

9. Mémoire à semi-conducteurs intégrée selon l'une des revendications 1 à 8, **caractérisée en ce que** chaque banc de mémoire (1, 2, 3, 4) comporte un décodeur d'adresse (17, 133) pour sélectionner des cellules de mémoire (13, 14, 15) via lequel il est possible de sélectionner des cellules de mémoire de seulement ce banc de mémoire.
